# EUROPÄISCHE PATENTSCHRIFT

(11) **EP 0 908 402 B1**
(45) Veröffentlichungstag und Bekanntmachung des Hinweises auf die Patenterteilung: **12.07.2000**
(21) Anmeldenummer: 97117335.6
(22) Anmeldetag: 07.10.1997
(51) Int. Cl.: B65G 47/90, B65H 29/04, H05K 13/00, B65B 5/06

(54) **Greifersystem für flache Bauteile**
Gripper arrangement for sheet-like articles
Système à pince pour articles en forme de feuille

(43) Veröffentlichungstag der Anmeldung: 14.04.1999
(73) Patentinhaber: Systronic Maschinenbau GmbH, 74223 Flein (DE)
(72) Erfinder: Krauss, Rainer, 74382 Neckarwestheim (DE)
(74) Vertreter: Schaumburg, Thoenes & Thurn

(56) Entgegenhaltungen:
- FR-A- 2 610 678
- GB-A- 458 301
- GB-A- 589 389
- US-A- 2 549 918

## Beschreibung

Die Erfindung betrifft ein Greifersystem für flache Bauteile, insbesondere für Leiterplatten und Leiterfolien.

Der Herstellungsprozeß von flachen Bauteilen wie beispielsweise Leiterplatten und Leiterfolien ist üblicherweise in mehrere Arbeitsschritte untergliedert. So werden Leiterplatten und Leiterfolien während ihrer Herstellung beispielsweise belichtet, geätzt, gereinigt, lackiert und auch getrocknet. Während des Transportes dieser flachen Bauteile sowohl zwischen den einzelnen Arbeitsstationen als auch in diesen werden sie üblicherweise von einem Greifer gehalten, um den Transport der meist sehr dünnen Bauteile zu erleichtern. Als Greifer werden beispielsweise Klemmen, Zangen oder ähnliches verwendet, in die die flachen Bauteile eingeführt und durch manuelles Betätigen eines Riegels oder einer Klemmvorrichtung in diesen fixiert werden. Bei diesen bekannten Greifern besteht nun die Gefahr, daß empfindliche, flache Bauteile wie Leiterplatten und Leiterfolien beim manuellen Einführen in den Greifer oder beim Klemmen durch den Greifer beschädigt werden.

Ein Greifersystem nach dem Oberbegriff des Anspruchs 1 ist aus der GB-A-458 301 bekannt.

Aus der US-A-2 549 918 ist ein Greifer bekannt, unter dessen Zuhilfenahme flache Bauteile wie Stahlbleche von Hand aufgenommen und gehalten werden können. Der Greifer hat einen Halteschlitz zur Aufnahme des Stahlbleches und ein in Richtung der Schlitzöffnung vorgespanntes Klemmelement. Das Klemmelement ist zwischen einer Klemmstellung, in der es zum Klemmen eines in den Halteschlitz eingeführten Stahlbleches in den Halteschlitz ragt, und einer offenen Stellung bewegbar, in der es zumindest teilweise aus dem Halteschlitz weggeschwenkt ist. Zum Verstellen des Klemmelementes von der Klemmstellung in die offene Stellung steht vom Klemmelement ein als Hebel ausgebildeter Stellabschnitt ab, der von Hand betätigt wird.

Es ist Aufgabe der Erfindung ein Greifersystem bereitzustellen, bei dem der Greifer auf einfache Weise störungsfrei automatisch betätigbar ist.

Diese Aufgabe wird durch ein Greifersystem mit den Merkmalen des Anspruchs 1 gelöst. Vorteilhafte Weiterbildungen ergeben sich aus den abhängigen Ansprüchen.

Der dem erfindungsgemäßen system zugehörige Greifer verwendet zum Halten der flachen Bauteile ein vorgespanntes Klemmelement. Zum Aufnehmen des flachen Bauteils wird das Bauteil in den Halteschlitz eingeführt, wobei das Bauteil bei seiner Einführbewegung das in Richtung der Schlitzöffnung vorgespannte Klemmelement zumindest teilweise aus dem Halteschlitz schwenkt. Sobald die Einführbewegung des Bauteils abgeschlossen ist, liegt das Klemmelement unter Vorspannung an dem im Halteschlitz aufgenommenen Abschnitt des Bauteils an und verklemmt es im Halteschlitz. Da das Klemmelement zwischen der offenen Stellung und der Klemmstellung uneingeschränkt schwenkbar ist, können flache Bauteile unterschiedlicher Dicke von wenigen hundertstel Millimetern bis zu mehreren Millimetern Materialdicke in den Halteschlitz eingeführt werden, wobei die Dicke des Bauteils nur durch die Abmessungen des Halteschlitzes beschränkt ist.

Vorzugsweise ist am Klemmelement ein Klemmabschnitt ausgebildet, der in der Klemmstellung in den Halteschlitz ragt und an dem mindestens ein Formelement ausgebildet ist, das zum Halten eines in den Halteschlitz eingeführten Bauteils mit dessen einer Flachseite in Eingriff kommt. Dabei verhindert das Formelement am Klemmelement ein Verrutschen oder Lösen des im Halteschlitz geklemmten Bauteils. Als Formelement wird beispielsweise eine Riffelung oder auch eine Verzahnung vorgeschlagen. Ferner ist es möglich, die Oberfläche des Klemmabschnittes aufzurauhen. Bei einer bevorzugten Ausführungsform dienen als Formelement mehrere auf einem gemeinsamen Teilkreis angeordnete Zähne.. Dabei ist das Klemmelement derart am Greifer schwenkbar gelagert, daß der dem Schlitzgrund am nächsten angeordnete Zahn in der Klemmstellung des Klemmelementes an der gegenüberliegenden Schlitzwand anliegt, wenn kein Bauteil in den Halteschlitz eingeführt ist. Durch die Anordnung der Zähne auf einem gemeinsamen Teilkreis kommt in Abhängigkeit von der Dicke des Bauteils durch die Schwenkbewegung des Klemmelements immer der zur Flachseite des Bauteils am nächsten angeordnete Zahn mit der Flachseite in Eingriff.

Des weiteren wird vorgeschlagen, am Klemmelement einen sich an den Klemmabschnitt anschließenden Stellabschnitt vorzusehen, der aus dem Greifer ragt und von dessen Oberseite absteht, wenn sich das Klemmelement in seiner Klemmstellung befindet. Auf diese Weise kann das Klemmelement durch Betätigen des aus dem Greifer ragenden Stellabschnitts in die offene Stellung geschwenkt werden, so daß der Klemmabschnitt das im Halteschlitz aufgenommene Bauteil freigibt. Bei dieser Ausführungsform des Klemmelements ist es besonders vorteilhaft, wenn der Stellabschnitt des Klemmelements abgeschrägt ist, in der Klemmstellung des Klemmelements eine von der Oberseite in Richtung der Schlitzöffnung des Halteschlitzes ansteigende Stellfläche bildet und in der offenen Stellung des Klemmelements parallel zur Oberseite verläuft. Auf diese Weise bildet der Stellabschnitt eine definierte Stellfläche, die durch eine entsprechende Vorrichtung betätigt werden kann und ein automatisches Öffnen des Greifers ermöglicht.

Um die Einführbewegung des Bauteils zu erleichtern, wird ferner vorgeschlagen, die die Schlitzöffnung des Halteschlitzes begrenzenden Längskanten derart abzurunden, daß die Schlitzöffnung erweitert ist. Durch die sich erweiternde Ausbildung der Schlitzöffnung des Halteschlitzes wird das Bauteil, sobald es mit der Schlitzöffnung in Berührung ist, in den sich verjüngenden Halteschlitz geführt.

Zum Öffnen des Greifers wird bei dem Greifersystem eine im Querschnitt U-förmige Öffnungsvorrichtung mit zwei zueinander beabstandeten Schenkeln verwendet, zwischen die der Greifer mit seinem dem Halteschlitz abgewandten Einsteckende einführbar ist. Zum Öffnen wird der Greifer derart in die Öffnungsvorrichtung eingeführt, daß die der Oberseite abgewandte Unterseite des Greifers am einen der Schenkel anliegt und der an der Oberseite anliegende andere Schenkel einen von der Oberseite des Greifers abstehenden Stellabschnitt des Klemmelements berührt und bei der Einführbewegung das Klemmelement in die offene Stellung schwenkt.

Bei einer bevorzugten Ausführungsform hat das Greifersystem einen ersten Träger mit mindestens einem ersten Greifer und einen parallel zu diesem verstellbar zweiten Träger mit mindestens einem weiteren Greifer. Dabei ist der Greifer am ersten Träger mit seinem Halteschlitz in Richtung des zweiten Trägers ausgerichtet. Der am zweiten Träger befestigte weitere Greifer ist mit seinem Halteschlitz zu dem Schlitz des ersten Greifers ausgerichtet. Durch Verstellen des zweiten Trägers kann ein aufzunehmendes flaches Bauteil zwischen den Greifern angeordnet werden. Anschließend kann der zweite Träger in Richtung des ersten Trägers verstellt werden, wobei der erste Greifer mit der ihm zugewandten Kante des flachen Bauteils und der weitere Greifer mit der der dieser gegenüberliegenden zweiten Kante des flachen Bauteils in Eingriff kommt. Zum Öffnen der Greifer können diese durch das Greifersystem in entsprechend vorgesehene Öffnungsvorrichtungen eingeführt werden, deren Aufbau beispielsweise dem zuvor beschriebenen Aufbau einer Öffnungsvorrichtung entspricht.

Weitere Merkmale und Vorteile der Erfindung ergeben sich aus der folgenden Beschreibung, welche in Verbindung mit den beigefügten Zeichnungen die Erfindung an Hand eines Ausführungsbeispiels erläutert. Es zeigen:
- Figur 1: eine Seitenansicht eines dem erfindungsgemäßen system zugehörigen Greifers,
- Figur 2: eine Draufsicht des Greifers nach Figur 1,
- Figur 3: eine Seitenansicht des Greifers nach Figur 1 vor dem Klemmen eines flachen Bauteils,
- Figur 4: eine Seitenansicht des Greifers nach Figur 1 während des Klemmens eines flachen Bauteils,
- Figur 5: eine Seitenansicht einer Öffnungsvorrichtung für den Greifer nach Figur 1 vor dem Öffnen desselben,
- Figur 6: eine Seitenansicht der Öffnungsvorrichtung nach Figur 5 beim Öffnen des Greifers nach Figur 1, und
- Figur 7: ein Greifersystem, das mehrere Greifer verwendet.

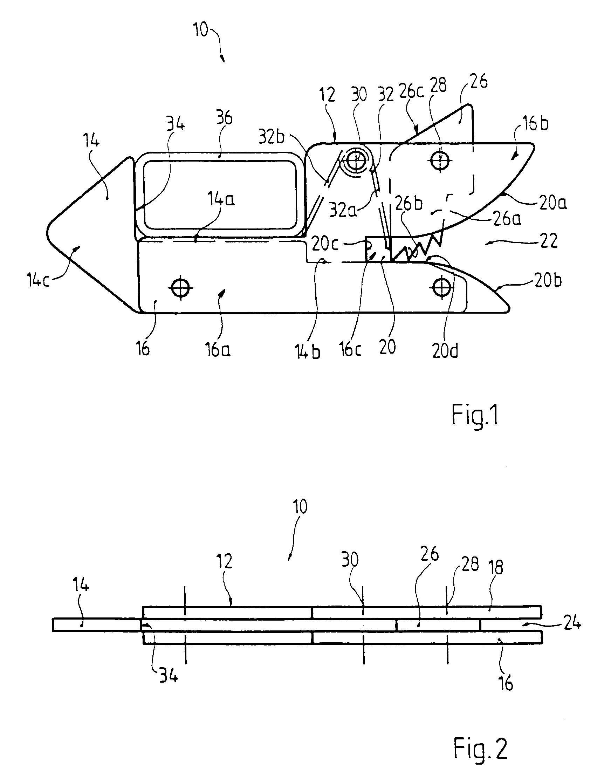

Nachfolgend wird an Hand der Figuren 1 und 2 der Aufbau eines Greifers 10 näher erläutert. Der Greifer 10 hat einen Greiferkörper 12, der aus einer Mittelplatte 14 gebildet ist, an deren jeweiliger Seitenfläche eine Seitenplatte 16 bzw. 18 durch Vernieten befestigt ist.

Die Mittelplatte 14 hat einen Befestigungsabschnitt 14a, einen Halteabschnitt 14b und einen Einführabschnitt 14c. Der Befestigungsabschnitt 14a hat eine rechteckige Form und geht mit seiner in Figur 1 rechts dargestellten Stirnseite unter Bildung eines Absatzes in den Halteabschnitt 14b über. Der Halteabschnitt 14b hat gleichfalls eine rechteckige Form und ist an seiner oberen Längskante leicht abgeschrägt. Die andere Stirnseite des Befestigungsabschnitts 14a geht in den Einführabschnitt 14c über, der die Form eines gleichschenkligen Dreiecks hat. Dabei bildet die in Figur 1 unten dargestellte Hälfte der die Hypothenuse des Dreiecks definierenden Kante des Einführabschnittes 14c den Übergang zu dem Befestigungsabschnitt 14a.

Die Seitenplatten 16 und 18 sind identisch ausgebildet, so daß nachfolgend nur die in Figur 1 dargestellte Seitenplatte 16 beschrieben wird. Die Seitenplatte 16 hat einen Befestigungsabschnitt 16a, der mit seiner in Figur 1 rechts dargestellten Stirnseite unter Bildung eines Absatzes in einen Halteabschnitt 16b übergeht. Der Halteabschnitt 16b hat an seiner dem Befestigungsabschnitt 16a abgewandten Stirnkante eine Ausnehmung 16c, die mit einer entsprechend ausgebildeten Ausnehmung der nicht dargestellten Seitenplatte 18 einen Halteschlitz 20 definiert. Der Halteschlitz 20 ist an seinen eine Schlitzöffnung 22 definierenden Längskanten 20a und 20b abgerundet und nach außen erweitert.

Wie Figur 2 zeigt, ist zwischen den Seitenplatten 16 und 18 ein Spalt 24 ausgebildet, in dem ein Klemmelement 26 angeordnet ist. Das Klemmelement 26 ist an einer parallel zur Schlitzöffnung 22 des Greifkörpers 12 verlaufenden Achse 28 schwenkbar gelagert, die durch die beiden Seitenplatten 16 und 18 ragt und an diesen befestigt ist. Das Klemmelement 26 besteht aus einem Klemmabschnitt 26a, der in den Halteschlitz 20 ragt, wenn das Klemmelement 26 in eine Klemmstellung geschwenkt ist. Der Klemmabschnitt 26a hat mehrere auf einem gemeinsamen Teilkreis angeordnete Zähne 26b, die zum Halten eines in den Halteschlitz 20 eingeführten Bauteils mit diesem in Eingriff kommen, wie später noch erläutert wird. Der dem Schlitzgrund 20c des Halteschlitzes 20 am nächsten angeordnete Zahn 26b liegt in der Klemmstellung des Klemmelements 26 am Halteabschnitt 14b der Mittelplatte 14 an, wenn kein Bauteil in den Halteschlitz 20 eingeführt ist. Das Klemmelement 26 hat ferner einen sich an den Klemmabschnitt 26a anschließenden Stellabschnitt 26c. Der Stellabschnitt 26c ist an seiner Oberseite abgeschrägt, ragt aus dem Greifkörper 12 und steht von diesem ab, wenn sich das Klemmelement 26 in seiner Klemmstellung befindet. Wird das Klemmelement 26 in eine offene Stellung geschwenkt, in der der Klemmabschnitt 26a aus dem Halteschlitz 20 weggeschwenkt ist, verläuft der Stellabschnitt 26c parallel zur Oberseite des Greifkörpers 12.

Von der Schlitzöffnung 22 aus gesehen hinter der Achse 28 ist parallel zu dieser eine Halteachse 30 angeordnet, die gleichfalls durch die Seitenplatten 16 und 18 ragt und an diesen befestigt ist. Auf die Halteachse 30 ist eine Torsionsfeder 32 aufgefädelt, die in dem Spalt 24 zwischen den beiden Seitenplatten 16 und 18 angeordnet ist. Die Torsionsfeder 32 liegt mit dem einen ihrer Federenden 32a an der der Torsionsfeder 32 zugewandten Seitenfläche des Klemmelements 26 an. Das andere Federende 32b ragt in eine durch die Seitenplatten 16 und 18 und den Einführabschnitt 14c der Mittelplatte 14 begrenzten Aussparung 34 von rechteckiger Form. In dieser Aussparung 34 ist ein im Querschnitt rechteckiges Hohlprofil 36 aufgenommen, an dem der Greifkörper 12 befestigt ist. Das in die Aussparung 34 ragende Federende 32b der Torsionsfeder 32 stützt sich am Hohlprofil 36 ab, wodurch die Torsionsfeder 32 vorgespannt wird. Durch die Vorspannung der Torsionsfeder 32 wird das Klemmelement 26 in Richtung der Schlitzöffnung 22 elastisch vorgespannt, wodurch das Klemmelement 26 mit seinem dem Schlitzgrund 20c des Halteschlitzes 20 am nächsten angeordneten Zahn 26b am Halteabschnitt 14b der Mittelplatte 14 anliegt, wie oben bereits beschrieben worden ist.

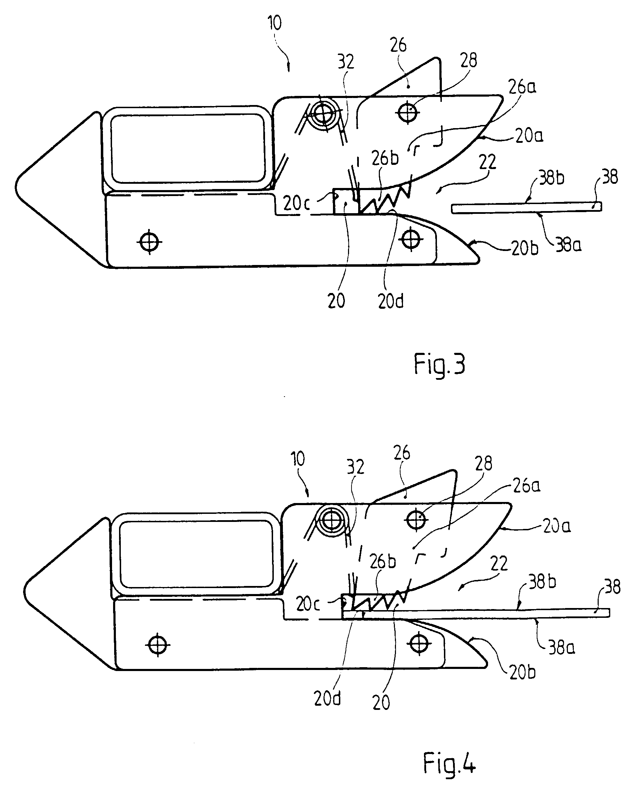

Nachfolgend wird unter Bezugnahme auf die Figuren 3 und 4 die Funktionsweise des Greifers 10 näher erläutert. Zum Halten eines flachen Bauteils 38, beispielsweise einer Leiterplatte, wird dieses durch die Schlitzöffnung 22 in den Halteschlitz 20 eingeführt. Dabei liegt das Bauteil 38 mit seiner in den Figuren 3 und 4 unten dargestellten Flachseite 38a an der unteren Schlitzwand 20d des Halteschlitzes 20 an. Gleichzeitig wird, sobald das Bauteil 38 mit dem Klemmabschnitt 26a des Klemmelements 26 in Berührung kommt, das Klemmelement 26 entgegen der Kraft der Torsionsfeder 32 im Uhrzeigersinn in Richtung des Schlitzgrunds 20c geschwenkt, wobei mindestens einer der Zähne 26b die obere Flachseite 38b des Bauteils 38 berührt.

Sobald die Einführbewegung des Bauteils 38 abgeschlossen ist, wie Figur 4 zeigt, und das Bauteil 38 mit seiner Stirnseite am Schlitzgrund 20c des Halteschlitzes 20 anliegt, ist das Klemmelement 26 durch die Kraft der Torsionsfeder 32 entgegen dem Uhrzeigersinn vorgespannt und einer der Zähne 26b liegt an der oberen Flachseite 38b des Bauteils 38 unter Vorspannung an, wodurch das Bauteil 38 im Halteschlitz 20 geklemmt ist.

Zum Lösen des Bauteils 38 kann der Benutzer den aus dem Greiferkörper 12 ragenden Stellabschnitt 26c des Klemmelements 26 in Richtung des Greifkörpers 12 nach unten drücken, wodurch das Klemmelement 26 im Uhrzeigersinn um die Achse 28 geschwenkt wird. Dadurch kommen die Zähne 26b mit der oberen Flachseite 38b des Bauteils 38 außer Eingriff, so daß das Bauteil 38 aus dem Halteschlitz 20 entfernt werden kann.

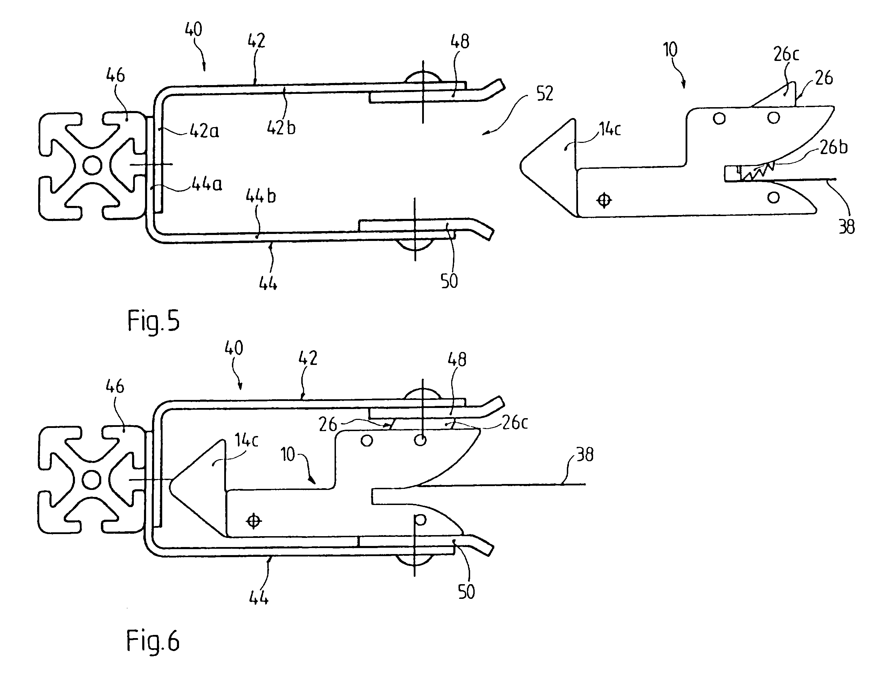

Eine weitere Möglichkeit zum Öffnen des Greifers 10 zeigen die Figuren 5 und 6. In den Figuren 5 und 6 ist eine im Querschnitt U-förmige Öffnungsvorrichtung 40 gezeigt. Die Öffnungsvorrichtung 40 besteht aus zwei im Querschnitt L-förmigen Schenkeln 42 und 44, die mit ihren kurzen Schenkelabschnitten 42a und 44a miteinander verbunden sind und so die U-förmige Öffnungsvorrichtung 40 bilden. Die U-förmige Öffnungsvorrichtung 40 ist ihrerseits durch eine Schraube (nicht dargestellt) an einer Profilstange 46 verschraubt. Jeder Schenkel 42 bzw. 44 hat am freien Ende seines langen Schenkelabschnitts 42b bzw. 44b eine Lasche 48 bzw. 50, die ihrerseits nach außen umgebogen ist. Dadurch bilden die beiden Laschen 48 und 50 eine sich erweiternde Einführöffnung 52 der U-förmigen Öffnungsvorrichtung 40. Zum Öffnen des Greifers 10, der ein flaches Bauteil 38 hält, wird dieser mit dem Einführabschnitt 14c seiner Mittelplatte 14 in die Einführöffnung 52 der Öffnungsvorrichtung 40 eingeführt. Dabei wird der Greifer 10 durch die Laschen 48 und 50 in die Einführöffnung 52 gelenkt. Sobald der Greifer 10 in die Öffnungsvorrichtung 40 eingeführt wird, liegt er mit seiner Unterseite an der unteren Lasche 50 des unteren Schenkels 44 an. Gleichzeitig kommt die obere Lasche 48 mit dem Stellabschnitt 26c des Klemmelements 26 in Berührung und schwenkt während der Einführbewegung des Greifers 10 in die Öffnungsvorrichtung 40 das Klemmelement 26 im Uhrzeigersinn. Dadurch wird das Klemmelement 26 in die offene Stellung geschwenkt und gibt das flache Bauteil 38 frei. Nachdem das flache Bauteil 38 entfernt worden ist, kann der Greifer 10 aus der Öffnungsvorrichtung 40 wieder herausgezogen werden und steht für einen erneuten Transport eines weiteren flachen Bauteils 38 bereit.

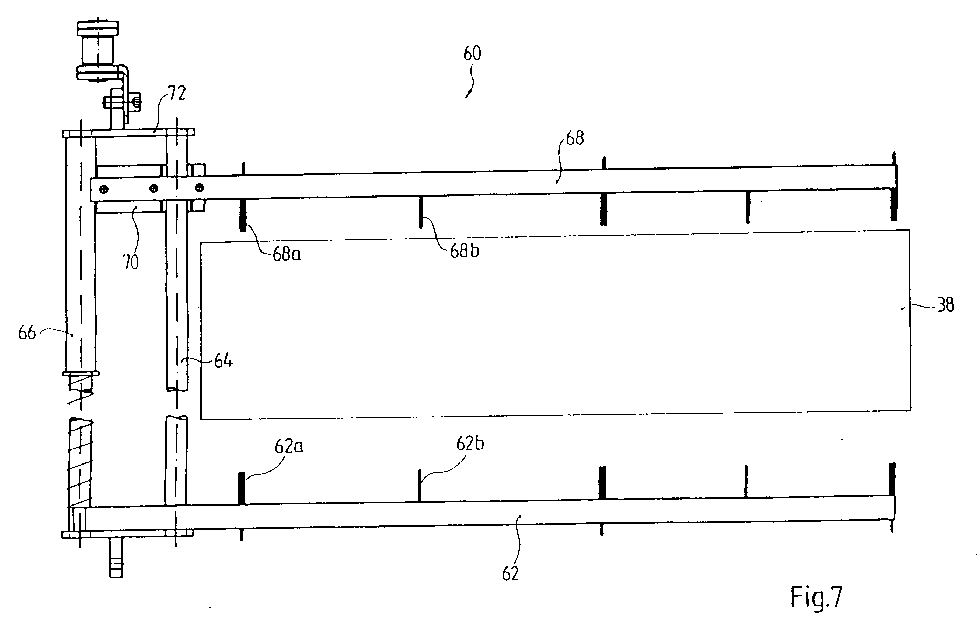

Figur 7 zeigt eine Draufsicht auf ein Greifersystem 60, das insgesamt sechs der zuvor beschriebenen Greifer 10 verwendet. Das Greifersystem 60 hat einen ersten Träger 62, der an zwei parallel zueinander verlaufenden Rundführungen 64 und 66 befestigt ist und senkrecht von diesen absteht. Parallel zum ersten Träger 62 ist ein zweiter Träger 68 angeordnet, der über eine Halterung 70 an den Rundführungen 64 und 66 gelagert und entlang diesen parallel zum ersten Träger 62 durch einen nicht dargestellten Antrieb verfahren werden kann. Das Greifersystem 60 ist seinerseits an einem Portal (nicht dargestellt) angelenkt und kann sowohl axial in drei senkrecht zueinander verlaufende Richtungen bewegt als auch um drei senkrecht zueinander verlaufende Drehachsen geschwenkt werden.

An jedem der Träger 62 und 68 sind jeweils drei identische Greifer 62a bzw. 68a befestigt, deren jeweiliger Aufbau dem Aufbau des Greifers 10 entspricht. Die Greifer 62a des ersten Trägers 62 sind mit ihren Halteschlitzen in Richtung des zweiten Trägers 68 zu den Greifern 68a des zweiten Trägers 68 ausgerichtet. Die Greifer 68a des zweiten Trägers 68 sind ihrerseits mit ihren Halteschlitzen zu den Halteschlitzen der Greifer 62a des ersten Trägers 62 ausgerichtet. Zwischen jedem benachbarten Greifer 62a des ersten Trägers 62 und den jeweils zueinander benachbarten Greifern 68a des zweiten Trägers 68 ist ferner jeweils ein Stützelement 62b bzw. 68b am ersten Träger 62 bzw. zweiten Träger 68 befestigt.

Nachfolgend wird die Funktionsweise des Greifersystems 60 erläutert. Sobald ein flaches Bauteil 38 von dem Greifersystem 60 aufgenommen werden soll, wird der zweite Träger 68 durch den nicht dargestellten Antrieb in eine Aufnahmestellung gefahren, in der er am in Figur 7 links dargestellten Anschlag 72 der Rundführungen 64 und 66 anliegt. Anschließend wird das Greifersystem 60 durch das Portal (nicht dargestellt) derart abgesenkt, daß das flache Bauteil 38 zwischen dem ersten Träger 62 und dem zweiten Träger 68 angeordnet ist. Danach wird der zweite Träger 68 durch den Antrieb (nicht dargestellt) in Richtung des ersten Trägers 62 verfahren, wobei die Greifer 68a am zweiten Träger 68 mit ihren Halteschlitzen an einer der Seitenkanten des flachen Bauteils 38 eingefädelt werden und dabei die Greifer 68a das Bauteil 38 erfassen. Gleichzeitig wird durch die Bewegung des zweiten Trägers 68 das flache Bauteil 38 in Richtung des ersten Trägers 62 verschoben, dessen Greifer 62a gleichfalls mit dem flachen Bauteil 38 in Eingriff kommen und so das flache Bauteil greifen. insbesondere bei sehr dünnen Bauteilen verhindern die zwischen den Greifern 62a bzw. 68a angeordneten Stützelemente 62b bzw. 68b ein Durchhängen des Bauteils, das den Transport und das Greifen des Bauteils 38 erschweren würde.

Nachdem der Transport durch das Greifersystem 68 abgeschlossen ist, wird das Greifersystem 68 mit seinem ersten Träger 62 in Richtung drei parallel zueinander angeordneter, an einer gemeinsamen Profilstange 46 befestigter Öffnungsvorrichtungen 40 bewegt, in die die Greifer 62a des ersten Trägers 62 eingeführt und durch die die Greifer 62a geöffnet werden, so daß das flache Bauteil 38 freigegeben ist. Anschließend wird der zweite Träger 68 wieder in seine Ausgangsstellung bewegt, in der er am Anschlag 72 der Rundführungen 64 und 66 anliegt. Dabei werden die Greifer 68a des zweiten Trägers 68 durch drei entsprechend angeordnete Öffnungsvorrichtungen 40 geöffnet, so daß das Bauteil freigegeben ist.

## Patentansprüche

1. Greifersystem für flache Bauteile, insbesondere für Leiterplatten und Leiterfolien, mit mindestens einem Greifer mit einem Halteschlitz (20) zur Aufnahme des Bauteils (38) und mit einem in Richtung der Schlitzöffnung (22) vorgespannten Klemmelement (26), das zwischen einer Klemmstellung, in der es in den Halteschlitz (20) ragt und das Bauteil einklemmt, und einer offenen Stellung mithilfe einer Öffnungsvorrichtung (40) schwenkbar ist, in der es zumindest teilweise aus dem Halteschlitz (20) weggeschwenkt ist, dadurch **gekennzeichnet,** daß die im Querschnitt U-förmige Öffnungsvorrichtung (40) zwei zueinander beabstandete Schenkel (42 und 44) hat, zwischen die der Greifer (10) mit seinem dem Halteschlitz (20) abgewandten Einsteckende (14c) derart einführbar ist, daß die der Oberseite abgewandte Unterseite des Greifers (10) am einen der Schenkel (44) anliegt und der an der Oberseite anliegende andere Schenkel (42) einen von der Oberseite des Greifers (10) abstehenden Stellabschnitt (26c) des Klemmelements (26) berührt und bei der Einführbewegung das Klemmelement (26) in die offene Stellung schwenkt.

2. Greifersystem nach Anspruch 1, dadurch **gekennzeichnet,** daß das Greifersystem (60) einen ersten Träger (62) mit mindestens einem ersten Greifer (62a) und einen parallel zu diesem verstellbaren zweiten Träger (68) mit mindestens einem weiteren Greifer (68a) hat, und daß der Greifer (62a) am ersten Träger (62) mit seinem Halteschlitz in Richtung des zweiten Trägers (68) ausgerichtet ist, und daß der am zweiten Träger (68) befestigte weitere Greifer (68a) mit seinem Halteschlitz zu dem Halteschlitz des ersten Greifers (62a) ausgerichtet ist.

3. Greifersystem nach Anspruch 1 oder 2, dadurch **gekennzeichnet,** daß am Klemmelement (26) ein Klemmabschnitt (26a) ausgebildet ist, der in der Klemmstellung in den Halteschlitz (20) ragt und an dem mindestens ein Formelement (26b) ausgebildet ist, das zum Halten eines in den Halteschlitz (20) eingeführten Bauteils (38) mit dessen einer Flachseite (38b) in Eingriff kommt.

4. Greifersystem nach Anspruch 3, dadurch **gekennzeichnet,** daß als Formelement mehrere auf einem gemeinsamen Teilkreis angeordnete Zähne (26b) dienen, und daß das Klemmelement (26) derart am Greifer (10) schwenkbar gelagert ist, daß der dem Schlitzgrund (20c) am nächsten angeordnete Zahn (26b) in der Klemmstellung des Klemmelements (26) an der gegenüberliegenden Schlitzwand (20d) anliegt, wenn kein Bauteil (38) in den Halteschlitz (20) eingeführt ist.

5. Greifer nach Anspruch 3 oder 4, dadurch **gekennzeichnet,** daß das Klemmelement (26) einen sich an den Klemmabschnitt (26a) anschließenden Stellabschnitt (26c) hat, der aus dem Greifer (10) ragt und von dessen Oberseite absteht, wenn sich das Klemmelement (26) in seiner Klemmstellung befindet.

6. Greifersystem nach Anspruch 5, dadurch **gekennzeichnet,** daß der Stellabschnitt (26c) des Klemmelements (26) abgeschrägt ist, in der Klemmstellung des Klemmelements (26) eine von der Oberseite in Richtung der Schlitzöffnung (22) des Halteschlitzes (20) ansteigende Stellfläche bildet und in der offenen Stellung des Klemmelements (26) parallel zur Oberseite verläuft.

7. Greifersystem nach einem der Ansprüche 1 bis 6, dadurch **gekennzeichnet,** daß die die Schlitzöffnung (22) des Halteschlitzes (20) begrenzenden Längskanten (20a und 20b) derart abgerundet sind, daß die Schlitzöffnung (22) erweitert ist.

8. Greifersystem nach einem der vorhergehenden Ansprüche, dadurch **gekennzeichnet,** daß das Klemmelement (26) durch eine Torsionsfeder (32) in die Klemmstellung vorgespannt ist.

9. Greifersystem nach Anspruch 8, dadurch **gekennzeichnet,** daß die Torsionsfeder (32) an einer parallel zur Schlitzöffnung (22) des Greifers (10) verlaufenden Achse (30) gelagert ist, mit dem einen seiner Federenden (32a) am Klemmelement (26) anliegt und mit dem anderen Federende (32b) am Greifer (10) befestigt ist.

## Claims

1. A gripper system for flat components, more particularly for printed circuit boards and films, comprising at least one gripper having a retaining slot (20) to receive the component (38) and having a clamping element (26) biased in the direction of the slot opening (22) and pivotable by means of an opening device (40) between a clamping position, in which it projects into the retaining slot (20) and clamps the component, and an open position in which it is at least partially pivoted out of the retaining slot (20), characterised in that the opening device (40), which is of U-shaped cross-section, has two spaced-apart limbs (42) and (44) between which the gripper (10) can be so introduced by its insertion end (14c) remote from the retaining slot (20) that the underside of the gripper (10) remote from the upper side abuts one of the limbs (44) and the other limb (42) abutting the upper side contacts an adjustment section (26c) of the clamping element (26) projecting from the upper side of the gripper (10) and pivots the clamping element (26) into the open position during the introduction movement.

2. A gripper system according to claim 1, characterised in that the gripper system (60) has a first member (62) with at least one gripper (62a) and a second member (68) adjustable parallel thereto and having at least one additional gripper (68a), and in that the gripper (62a) on the first member (62) is aligned with its retaining slot in the direction of the second member (68) and in that the additional gripper (68a) fixed on the second member (68) is aligned with its retaining slot to the retaining slot of the first gripper (62a).

3. A gripper system according to claim 1 or 2, characterised in that the clamping element (26) is formed with a clamping section (26a) which in the clamping position projects into the retaining slot (20) and on which at least one shaped element (26b) is formed which, for the purpose of holding a component (38) introduced into the retaining slot (20), comes into engagement with one flat side (38b) thereof.

4. A gripper system according to claim 3, characterised in that the shaped element is in the form of a plurality of teeth (26b) disposed on a common pitch circle, and in that the clamping element (26) is mounted for pivoting on the gripper (10) in such manner that the tooth (26b) nearest the slot base (20c) abuts the opposite slot wall (20d) in the clamping position of the clamping element (26) when no component (38) has been introduced into the retaining slot (20).

5. A gripper according to claim 3 or 4, characterised in that the clamping element (26) has an adjustment section (26c) which adjoins the clamping section (26a) and which projects from the gripper (10) and from the upper side thereof when the clamping element (26) is in its clamping position.

6. A gripper system according to claim 5, characterised in that the adjustment section (26c) of the clamping element (26) is bevelled, forms an adjustment surface which slopes from the upper side in the direction of the slot opening (22) of the retaining slot (20) when the clamping element (26) is in the clamping position and extends parallel to the upper side when the clamping element (26) is in the open position.

7. A gripper system according to any one of claims 1 to 6, characterised in that the longitudinal edges (20a) and (20b) defining the opening (22) of the retaining slot (20) are so rounded that the slot opening (22) is widened.

8. A gripper system according to any one of the preceding claims, characterised in that the clamping element (26) is biased into the clamping position by means of a torsion spring (32).

9. A gripper system according to claim 8, characterised in that the torsion spring (32) is mounted on a spindle (30) extending parallel to the slot opening (22) of the gripper (10), abuts the clamping element (26) by one of its spring ends (32a), and is fixed on the gripper (10) by the other spring end (32b).

## Revendications

1. Système à pince pour composants plats, en particulier pour cartes de circuits imprimés et plaquettes imprimées, comportant au moins une pince dotée d'une fente de retenue (20) pour recevoir le composant (38), et un élément de serrage (26) précontraint en direction de l'ouverture (22) de la fente, lequel élément de serrage peut pivoter entre une position de serrage dans laquelle il fait saillie dans la fente de retenue (20) et serre le composant, et une position ouverte avec l'aide d'un dispositif d'ouverture (40) dans laquelle il a pivoté et s' est écarté au moins partiellement de la fente de retenue (20), caractérisé en ce que le dispositif d'ouverture (40), ayant une forme en U en coupe transversale, possède deux ailes (42 et 44) distantes l'un de l'autre, entre lesquelles la pince (10) dotée de son embout (14c) opposé à la fente de retenue (20) est insérable de façon que la face inférieure opposée à la face supérieure de la pince (10) soit adjacente à une des ailes (44), et de façon que l'autre aile (42) adjacente au côté supérieur contacte une portion de commande (26c) de l'élément de serrage (26) dépassant de la face supérieure de la pince (10) et lors du mouvement d'insertion pivote l'élément de serrage (26) dans la position ouverte.

2. Système à pince selon la revendication 1, caractérisé en ce que le système à pince (60) comporte un premier support (62) doté d'au moins une première pince (62a) et un second support (68) déplaçable parallèlement au premier support et doté d'au moins une autre pince (68a), et en ce que la pince (62a) du premier support (62) a sa fente de retenue qui est tournée vers le second support (68), et l'autre pince (68a) fixée au second support (68) a sa fente de retenue qui est tournée vers la fente de retenue de la première pince (62a).

3. Système à pince selon la revendication 1 ou 2, caractérisé en ce que l'élément de serrage (26) comporte une portion de serrage (26a) qui fait saillie dans la fente de retenue (20) dans la position de serrage et qui possède au moins un élément conformé (26b) qui, pour retenir un composant (38) inséré dans la fente de retenue (20), vient en prise avec l'une de ses faces plates (38b).

4. Système à pince selon la revendication 3, caractérisé en ce que l'élément conformé est constitué par plusieurs dents (26b) agencées sur un cercle primitif commun, et en ce que l'élément de serrage (26) est monté sur la pince (10) de façon à pouvoir pivoter de telle sorte que la dent (26b) la plus proche du fond (20c) de la fente dans la position de serrage de l'élément de serrage (26) porte sur la paroi opposée (20d) de la fente lorsqu'aucun composant (38) n'est inséré dans la fente de retenue (20).

5. Système à pince selon la revendication 3 ou 4, caractérisé en ce que l'élément de serrage (26) comporte une portion de commande (26c), se raccordant à la portion de serrage (26a), qui fait saillie de la pince (10) et qui est distante de la face supérieure de celle-ci lorsque l'élément de serrage (26) se trouve dans sa position de serrage.

6. Système à pince selon la revendication 5, caractérisé en ce que la portion de commande (26c) de l'élément de serrage (26) est chanfreinée, formant, dans la position de serrage de l'élément de serrage (26), une surface de commande inclinée vers le haut depuis la face supérieure en direction de l'ouverture (22) de la fente de retenue (20) et s'étendant, dans la position ouverte de l'élément de serrage (26), parallèlement à la face supérieure.

7. Système à pince selon l'une des revendications 1 à 6, caractérisé en ce que les arêtes longitudinales (20a et 20b) délimitant l'ouverture (22) de la fente de retenue (20) sont arrondies de sorte que l'ouverture (22) de la fente s'évase.

8. Système à pince selon l'une des revendications précédentes, caractérisé en ce que l'élément de serrage (26) est précontraint par un ressort de torsion (32) dans la position de serrage.

9. Système à pince selon la revendication 8, caractérisé en ce que le ressort de torsion (32) est monté sur un axe (30) s'étendant parallèlement à l'ouverture (22) de la fente de la pince (10), une des extrémités (32a) du ressort portant sur l'élément de serrage (26) et l'autre extrémité (32b) du ressort étant fixée à la pince (10).
